# EUROPÄISCHE PATENTSCHRIFT

(11) **EP 3 414 802 B1**
(45) Veröffentlichungstag und Bekanntmachung des Hinweises auf die Patenterteilung: **23.09.2020**
(21) Anmeldenummer: 16703970.0
(22) Anmeldetag: 10.02.2016
(51) Int. Cl.: H01S 3/00, H05G 2/00, H01S 3/23, H01S 3/223

(54) **TREIBERLASERANORDNUNG MIT EINEM OPTISCHEN ISOLATOR UND EUV-STRAHLUNGSERZEUGUNGSVORRICHTUNG DAMIT**
DRIVING SYSTEM FOR A LASER WITH AN OPTICAL ISOLATOR AND AN EUV-RADIATION GENERATION SYSTEM WITH THE DRIVING SYSTEM
ENSEMBLE LASER D'ATTAQUE AVEC UN ISOLATOR OPTIQUE ET DISPOSITIF DE GÉNÉRATION D'UN RAYONNEMENT EUV AVEC LEDITE ENSEMBLE

(43) Veröffentlichungstag der Anmeldung: 19.12.2018
(73) Patentinhaber: TRUMPF Lasersystems for Semiconductor Manufacturing GmbH, 71254 Ditzingen (DE)
(72) Erfinder: BRUNNE, Jens, 70180 Stuttgart (DE); WISSERT, Matthias, 70176 Stuttgart (DE); KRAUSS, Günther, 71254 Ditzingen (DE)
(74) Vertreter: Kohler Schmid Möbus Patentanwälte
(86) Internationale Anmeldenummer: PCT/EP2016/052774
(87) Internationale Veröffentlichungsnummer: WO 2017/137074

(56) Entgegenhaltungen:
- WO-A1-2017/101982
- US-A- 4 194 813
- US-A1- 2016 007 434
- FIGUEIRA J F ET AL: "PLASMA-BREAKDOWN RETROPULSE ISOLATORS FOR THE INFRARED", APPLIED OPTICS, OPTICAL SOCIETY OF AMERICA, WASHINGTON, DC; US, Bd. 20, Nr. 5, 1. März 1981 (1981-03-01), Seiten 838-841, XP000708968, ISSN: 0003-6935, DOI: 10.1364/AO.20.000838

## Beschreibung

Die vorliegende Erfindung betrifft eine Treiberlaseranordnung für eine EUV-Strahlungserzeugungsvorrichtung. Die Erfindung betrifft auch eine EUV-Strahlungserzeugungsvorrichtung mit einer solchen Treiberlaseranordnung.

So genannte Laser Produced Plasma, LLP, EUV-Lichtquellen bzw. EUV-Strahlungserzeugungsvorrichtungen weisen eine Treiberlaseranordnung auf, die eine Strahlquelle, beispielsweise einen CO₂-Laser, zur Erzeugung von gepulster Laserstrahlung (d.h. einer Folge von Laserpulsen) umfasst. Die gepulste Laserstrahlung wird typischer Weise von mehreren optischen Verstärkern einer Verstärkeranordnung der Treiberlaseranordnung verstärkt. Die von der Treiberlaseranordnung erzeugte und verstärkte Laserstrahlung wird über eine Strahlführungseinrichtung einer Fokussiereinrichtung zugeführt, welche die Laserstrahlung in einem Zielbereich fokussiert, an dem ein Target-Material, beispielsweise in Form von Zinn-Tröpfchen, bereitgestellt wird, das bei der Bestrahlung mit der Laserstrahlung in einen Plasma-Zustand übergeht und hierbei EUV-Strahlung emittiert.

Bei einer solchen EUV-Strahlungserzeugungsvorrichtung wird ein Anteil der gepulsten Laserstrahlung an dem Target-Material zurück reflektiert und durchläuft die Strahlführungseinrichtung und die optischen Verstärker der Verstärkeranordnung in Rückwärtsrichtung, so dass die rückreflektierte Laserstrahlung ebenfalls verstärkt wird. Dadurch nimmt die Verstärkung des Verstärkermediums in den optischen Verstärkern ab, so dass sich die maximal erzielbare Leistung bei der Verstärkung der in Vorwärtsrichtung, d.h. in Richtung auf das Target-Material, propagierenden Laserstrahlung verringert. Typischer Weise ist es auch erforderlich, die rückreflektierte Laserstrahlung zu filtern, um die Strahlquelle vor einer Zerstörung durch die rückreflektierte Laserstrahlung zu schützen. Wenn herkömmliche optische Isolatoren z.B. in Form von Faraday-Isolatoren oder in Form von elektro-optischen Modulatoren verwendet werden, ist dies nur bis zu einer begrenzten Maximalleistung der Laserstrahlung möglich, da die optischen Isolatoren ansonsten durch die rückreflektierte Laserstrahlung geschädigt werden.

Aus der WO 2015/082004 A1 ist eine Verstärkeranordnung beispielsweise für eine Treiberlaseranordnung einer EUV-Strahlungserzeugungsvorrichtung bekannt geworden, wobei die Verstärkeranordnung einen optischen Isolator aufweist, der eine Polarisator-Einrichtung sowie eine Phasenschiebe-Einrichtung umfasst. Zumindest die Polarisator-Einrichtung ist an einem Ort positioniert, an dem die Laserstrahlung eine Laserleistung von mehr als 500 W aufweist.

Durch die optische Filterung in einem optischen Isolator, der wie weiter oben beschrieben ausgebildet ist, wird in dem filternden Element des optischen Isolators typischer Weise eine thermische Linse erzeugt, welche die Divergenz bzw. die Strahleigenschaften der vorwärtslaufenden Laserstrahlung bzw. des vorwärtslaufenden Laserstrahls auf ungünstige Weise verändert. Wird außerdem die maximale Leistungsgrenze des filternden optischen Elements erreicht, muss die EUV-Strahlungserzeugungsvorrichtung bzw. die EUV-Lithographieanlage abgeschaltet werden. Da ein Neustart der EUV-Lithographieanlage einen signifikanten Zeitverlust bedingt, wird dadurch die Produktivität der EUV-Lithographieanlage reduziert.

Erschwerend kommt bei der vorliegenden Anwendung hinzu, dass optische Isolatoren, welche auf dem Prinzip der Polarisation bzw. Phasenverschiebung basieren, bauartbedingt nur Laserstrahlung mit einem bestimmten Phasensprung bzw. mit einer bestimmten Phasenverschiebung (bspw. 180°) unterdrücken können. Der Wert für diesen Phasensprung bzw. für diese Phasenverschiebung wird ggf. bei der Reflexion an einem Tröpfchen nicht eingehalten, so dass die an dem Tröpfchen reflektierte Laserstrahlung auch aus diesem Grund von einem solchen optischen Isolator nicht vollständig unterdrückt werden kann.

In der WO 2015/045102 A1 ist eine Laservorrichtung beschrieben, die einen Master-Oszillator aufweist, der einen gepulsten Laserstrahl emittiert. Der gepulste Laserstrahl wird in einer Mehrzahl von optischen Verstärkern verstärkt, die im optischen Strahlweg des gepulsten Laserstrahls angeordnet sind. Die Laservorrichtung kann zusätzlich einen Lichtreflektor aufweisen, der es dem gepulsten Laserstrahl erlaubt, durch diesen hindurchzutreten, wobei der Lichtreflektor selbst-oszillierende Strahlung reflektiert, die an einem der Mehrzahl von Verstärkern erzeugt wird. Die Laservorrichtung weist auch einen Strahlungsabsorber auf, der die selbst-oszillierende Strahlung, die von dem Lichtreflektor reflektiert wird, aufnimmt und absorbiert.

In der US 2015/0208494 A1 ist eine EUV-Lichtquelle beschrieben, bei der ein Target-Material an einer Zielposition bereitgestellt wird und ein verstärkter Laserstrahl, der in Richtung auf die Zielposition propagiert, wird in einer Fokusebene fokussiert. Die Zielposition befindet sich außerhalb der Fokusebene und eine Wechselwirkung zwischen dem verstärkten Laserstrahl und dem Target-Material wandelt zumindest einen Teil des Target-Materials in ein Plasma um, das EUV-Strahlung emittiert. Auf diese Weise sollen Rückreflexe in der EUV-Lichtquelle reduziert werden.

Aus der US 4,194,813 ist ein optischer Isolator zur Unterdrückung von Rückreflexen bekannt geworden, die von einem mittels eines Lasers bestrahlten Target ausgehen. Der optische Isolator weist eine in einer Vakuum-Kammer angeordnete Scheibe, z.B. aus Aluminium oder aus Tantal, mit einer Blendenöffnung auf, die in dem durch die Kammer geführten Strahlengang des Lasers angeordnet ist. Der Isolator weist zusätzlich Mittel zur Fokussierung von Laserstrahlung auf den Rand der Blendenöffnung auf, um den Rand der Blendenöffnung zu beschädigen und hierbei ein Plasma zu erzeugen. In der US 4,194,813 wird auch angegeben, dass andere Verfahren bekannt sind, um einen CO₂-Laserstrahl vor seinem Rückreflex an einem Target zu schützen, wobei diese Verfahren üblicher Weise die Bildung einer Plasmaentladung in Luft umfassen. Ein solches Verfahren umfasst eine Entladung an einer Folie aus Mylar durch den Laserpuls selbst oder durch einen Hilfslaserstrahl. Andere Verfahren umfassen eine Gasentladung in der Nähe eines Fokuspunkts, wobei ein Reflektor verwendet wird, um die Energie des Randbereichs des Laserstrahls in einem Zentrum zu konzentrieren, so dass das elektrische Feld des Laserstrahls eine Plasmazündschwelle in Luft überschreitet. Anderswo sollen Entladungen durch die Anwendung eines Überspannungs-Pulses auf einen kleinen Bereich erzeugt werden, wobei der Puls mit dem Laserstrahl synchronisiert ist.

WO 2017/101982 A1 gilt als Stand der Technik u. Art. 54(3) EPÜ und zeigt eine Treiberlaseranordnung für eine Vorrichtung zur Erzeugung von EUV-Strahlung, umfassend: eine Strahlquelle zur Erzeugung von Laserstrahlung, die in einer ersten Richtung (R1) propagiert, eine Verstärkeranordnung mit drei optischen Verstärkern zur Verstärkung der in der ersten R1-Richtung propagierenden Laserstrahlung, und einen optischen Isolator, mit einer mit einem Gas gefüllten Kammer, die von der in der R1-Richtung propagierenden Laserstrahlung durchlaufen wird und die eine Plasmaerzeugungseinrichtung zur gepulsten Zündung eines Plasmas aufweist, sodass der Durchtritt von Laserstrahlung, die in einer zweiten entgegen gesetzten Richtung propagiert, unterdrückt wird. Ein Gaskreislauf dient der Zu- und Abführung des Gases in die Kammer und aus der Kammer.

Zusätzlich zu dem Problem von Rückreflexen kann es bei der Verstärkung von Laserpulsen in einer optischen Verstärkeranordnung bzw. generell in einem optischen Verstärker zu so genannten Selbst-Oszillationen ("self-lasing") bzw. zu so genannter ASE ("amplified spontaneous emission") kommen, d.h. zu verstärkten spontanen Emissionen, die zur Begrenzung der Verstärkung in einer jeweiligen Verstärker-Stufe und im schlimmsten Fall sogar zu deren Zerstörung führen können. ASE erhöht den Signaluntergrund, so dass auch ohne das Vorhandensein eines zu verstärkenden Eingangssignals in Form eines gepulsten Laserstrahls bzw. in Form von Laserpulsen in einem optischen Verstärker Strahlung erzeugt wird. Das Self-Lasing in einer Verstärkeranordnung kann zwar durch eine Reduzierung der reflektierenden Oberflächen eingeschränkt werden, um auf diese Weise die Anzahl der Durchläufe zu verringern, kann aber in der Regel nicht vollständig unterdrückt werden.

### Aufgabe der Erfindung

Der Erfindung liegt die Aufgabe zugrunde, eine Treiberlaseranordnung sowie eine EUV-Strahlungserzeugungsvorrichtung bereitzustellen, die einen effektiven Plasmarückreflexschutz und ggf. die Unterdrückung von Self-Lasing ermöglichen.

### Gegenstand der Erfindung

Diese Aufgabe wird gelöst durch eine Treiberlaseranordnung wie in Anspruch 1 definiert. Bevorzugte Ausführungen sind in den abhängigen Ansprüchen 2-17 definiert.

Bei der erfindungsgemäßen Treiberlaseranordnung ist die Plasmaerzeugungseinrichtung ausgebildet, zur gepulsten Zündung eines Plasmas bzw. einer Gasentladung direkt auf das in der Kammer befindliche Gas einzuwirken. d.h. direkt mit Gas in der Kammer in Wechselwirkung zu treten. Anders als in der eingangs zitierten US 4,194,813 wird das Plasma bei der hier beschriebenen Plasmaerzeugungseinrichtung nicht durch eine Wechselwirkung der Laserstrahlung mit einem in der Kammer vorhandenen verdampfbaren Material, z.B. in Form einer Blende bzw. eines Randes einer Blendenöffnung, erzeugt. Beispielsweise kann in der Kammer kein verdampfbares Material z.B. in Form einer Blende vorhanden sein. Falls in der Kammer eine verdampfbares Material, z.B. eine Blende, angeordnet ist, ist der Ort, an dem das Plasma in dem Gas der Kammer erzeugt wird, von der Blende beabstandet, d.h. auch in diesem Fall erfolgt die Gasentladung bzw. die Plasmaerzeugung durch eine direkte Einwirkung bzw. Wechselwirkung der Plasmaerzeugungseinrichtung mit dem in der Kammer befindlichen Gas und nicht mittelbar über die Verdampfung von Material.

Die Kammer weist typischer Weise ein Eintrittsfenster zum Eintritt der in der ersten Richtung propagierenden Laserstrahlung in die Kammer sowie ein Austrittsfenster zum Austritt der in der ersten Richtung propagierenden Laserstrahlung aus der Kammer auf. Die in der zweiten Richtung propagierende, gepulste Laserstrahlung wird durch die gepulste Zündung des Plasmas bzw. die Gasentladung typischer Weise am Durchtritt durch die Kammer gehindert, d.h. die in der zweiten Richtung propagierende Laserstrahlung tritt an dem Austrittsfenster in die Kammer ein, aber an dem Eintrittsfenster nicht mehr oder zumindest deutlich abgeschwächt aus der Kammer aus. Der Ort in der Kammer, an dem die Wechselwirkung der Plasmaerzeugungseinrichtung mit dem Gas der Kammer erfolgt, ist grundsätzlich beliebig, überschneidet sich aber in der Regel zumindest teilweise mit dem Strahlengang der in der ersten bzw. in der zweiten Richtung propagierenden Laserstrahlung, um den Durchtritt der in der zweiten Richtung propagierenden Laserstrahlung durch die Kammer wirksam zu verhindern bzw. möglichst stark zu unterdrücken.

Die hier beschriebene Lösung eignet sich prinzipiell sowohl für Laserstrahlung, die von Gaslasern, beispielsweise von CO₂-Gaslasern, erzeugt wird und in entsprechenden optischen Verstärkern verstärkt wird, als auch für Laserstrahlung, die von Festkörperlasern oder ggf. von anderen Lasern, beispielsweise von Faserlasern, erzeugt wird und die in entsprechenden optischen Verstärkern verstärkt wird. Die Erzeugung eines Plasmas mit Hilfe von Laserstrahlung ist beispielsweise aus dem Artikel "Picosecond air breakdown studies at 0.53 µm", W. E. Williams et al., Appl. Phys. Lett. 43(4), 1983, 352-354 oder dem Artikel "Focal-length dependence of air breakdown by a 20-psec laser pulse", Applied Physics Letters, 24 (5), 1974, bekannt geworden.

Der optische Isolator weist einen Gaskreislauf zur Zuführung des Gases in die Kammer und zur Abführung des Gases aus der Kammer auf. Die Kammer ist gasdicht und weist typischer Weise mindestens einen Gaseinlass und mindestens einen Gasauslass auf, um das Gas in der Kammer möglichst schnell auszutauschen. Der Gasdruck in der Kammer kann mittels einer Gasdruck-Einstelleinrichtung durch die Strömungsgeschwindigkeit des Gases bzw. durch eine (schnelle) Durchfluss-Steuerung bzw. Durchfluss-Regelung des Gases durch die Kammer eingestellt bzw. geregelt werden. Das Gas kann innerhalb eines geschlossenen Gas-Kreislaufs umlaufen, wobei die Umwälzung des Gases mittels einer Pumpe erfolgt. Wird als Pumpe ein Gebläse, beispielsweise ein Turboradialgebläse, verwendet, kann das Gas gleichzeitig gekühlt und die in dem Plasma absorbierte Leistung kann abgegeben werden, bevor das Gas erneut über den Gaseinlass zurück in die Kammer strömt.

Bei einer Ausführungsform umfasst der optische Isolator zusätzlich eine Fokussiereinrichtung zur Fokussierung der in der ersten Richtung propagierenden Laserstrahlung auf einen Laserstrahlfokus in der Kammer, sowie bevorzugt eine Kollimationseinrichtung zur Kollimation der von dem Laserstrahlfokus ausgehenden, in der ersten Richtung propagierenden Laserstrahlung. Typischer Weise tritt die in der ersten Richtung propagierende Laserstrahlung durch das Eintrittsfenster kollimiert in die Kammer ein und durch das Austrittsfenster kollimiert aus der Kammer aus. Die Fokussiereinrichtung und die Kollimationseinrichtung können insbesondere ein Strahlteleskop bilden, d.h. diese sind im Wesentlichen im Abstand ihrer Brennweiten voneinander angeordnet. An dem Laserstrahlfokus weist die Laserstrahlung ihre maximale Intensität in der Kammer auf, so dass die Gasentladung bzw. das Plasma, wenn dieses durch die in der zweiten Richtung propagierende Laserstrahlung gezündet wird, typischer Weise im Bereich des Laserstrahlfokus erzeugt wird. Sowohl die Fokussiereinrichtung als auch die Kollimationseinrichtung können eines oder mehrere reflektierende optische Elemente, beispielsweise in Form von Spiegeln, und/oder eines oder mehrere transmissive optische Elemente, beispielsweise in Form von Linsen, aufweisen.

Eine Intensität der in der ersten Richtung propagierenden Laserstrahlung in dem Gas der Kammer, insbesondere an dem Laserstrahlfokus, kann kleiner sein als eine Plasmazündschwelle zur Zündung der Gasentladung in dem Gas der Kammer und die Intensität der in der zweiten Richtung propagierenden Laserstrahlung in dem Gas der Kammer, insbesondere an dem Laserstrahlfokus, kann größer sein als die Plasmazündschwelle zur Erzeugung der Gasentladung in dem Gas der Kammer. Ist dies der Fall, wird durch die in der zweiten Richtung propagierende, gepulste Laserstrahlung in dem Gas der Kammer eine Gasentladung bzw. ein Plasma gezündet. Die in der zweiten Richtung propagierende Laserstrahlung wird in dem Plasma -je nach Intensität - absorbiert oder reflektiert und verlässt somit nicht die Kammer durch das Eintrittsfenster in Richtung auf die Strahlquelle sowie auf ggf. zwischen der Strahlquelle und dem optischen Isolator angeordnete weitere optische Elemente, die ebenfalls durch die in der zweiten Richtung propagierende Laserstrahlung geschädigt werden könnten.

Die Fokussiereinrichtung und die Kollimationseinrichtung dienen in diesem Fall gemeinsam als Plasmaerzeugungseinrichtung, wobei die Intensität der in der ersten Richtung propagierenden Laserstrahlung an dem Laserstrahlfokus typischer Weise so gewählt ist, dass diese knapp unterhalb der Plasmazündschwelle liegt. Die Intensität der in der zweiten Richtung propagierenden Laserstrahlung, bei der es sich typischer Weise um in der Verstärkeranordnung verstärkte und zur Verstärkeranordnung zurückreflektierte Laserstrahlung der Strahlquelle handelt, ist bei geeigneter Anordnung des optischen Isolators in der Treiberlaseranordnung, genauer gesagt in der Verstärkeranordnung, größer als die Intensität der in der ersten Richtung propagierenden Laserstrahlung, so dass der optische Isolator einen rein passiven Rückreflexschutz bildet, der auf einem von der in der zweiten Richtung propagierenden Laserstrahlung gezündeten Plasma beruht. Mit anderen Worten löscht sich der in der zweiten Richtung propagierende Laserstrahl in der Kammer durch die Gasentladung bzw. die Bildung des Plasmas selbst aus.

Der optische Isolator ist bevorzugt an einem Ort in der Verstärkerkette angeordnet, an dem die in der ersten Richtung propagierende Laserstrahlung eine höhere Intensität bzw. Leistung aufweist als die in der zweiten Richtung propagierende, rückreflektierte Laserstrahlung. Bei einer Verstärkeranordnung, die einen oder mehrere in Reihe geschaltete optische Verstärker aufweist, ist der optische Isolator bevorzugt im Strahlweg der in der ersten Richtung propagierenden Laserstrahlung vor einem ersten (optischen) Verstärker, vor einem zweiten (optischen) Verstärker oder vor einem dritten (optischen) Verstärker der Verstärkeranordnung angeordnet. Ist der optische Verstärker vor dem zweiten optischen Verstärker angeordnet, weist die Verstärkeranordnung in der Regel mindestens drei optische Verstärker auf, d.h. auf den zweiten optischen Verstärker folgt mindestens ein weiterer (dritter) optischer Verstärker. Gleiches gilt für den Fall, dass der optische Isolator vor dem dritten optischen Verstärker angeordnet ist, d.h. es folgt mindestens ein weiterer (vierter) optischer Verstärker auf den dritten optischen Verstärker, vor dem der optische Isolator angeordnet ist.

Das Eintrittsfenster der Kammer kann mit einem Austrittsfenster eines der optischen Verstärker zusammenfallen. Ebenso kann das Austrittsfenster der Kammer mit dem Eintrittsfenster eines weiteren, nachfolgenden optischen Verstärkers der Verstärkeranordnung zusammenfallen, um einen minimalen Materialaufwand sowie eine kompakte Bauform zu ermöglichen. Es ist aber auch möglich, die Kammer räumlich getrennt von den optischen Verstärkern anzuordnen.

Bei einer weiteren Ausführungsform ist der optische Isolator ausgebildet, eine Plasmazündschwelle zur Zündung des Plasmas in der Kammer sowie ggf. zur Einstellung der optischen Eigenschaften des Plasmas (absorbierend oder reflektierend) einzustellen. Die Plasmazündschwelle in dem Gas der Kammer hängt von unterschiedlichen Parametern ab, von denen mindestens einer variiert werden kann, um die Plasmazündschwelle zu verändern bzw. einzustellen. Bei diesen Parametern handelt es sich beispielsweise um den Gasdruck in der Kammer, um die Zusammensetzung des Gases in der Kammer sowie um die (maximale) Intensität der (gepulsten) Laserstrahlung in der Kammer.

Bei einer Weiterbildung ist/sind die Fokussiereinrichtung und/oder die Kollimationseinrichtung zur Einstellung eines Fokusdurchmessers des Laserstrahlfokus in der Kammer ausgebildet. Mit Hilfe einer adaptiven Fokussier- und Kollimationseinrichtung kann die (maximale) Intensität der Laserstrahlung in der Kammer, die an dem Laserstrahlfokus auftritt, über den Durchmesser des Laserstrahlfokus eingestellt werden, um die Plasmazündschwelle zu verändern.

Bei einer Weiterbildung umfassen die Fokussiereinrichtung und/oder die Kollimationseinrichtung mindestens ein entlang einer Strahlrichtung der Laserstrahlung verschiebbares und/oder mindestens ein in seiner Brennweite veränderbares optisches Element. Bei dem in seiner Brennweite veränderbaren optischen Element kann es sich z.B. um einen adaptiven Spiegel oder um eine adaptive Linse handeln, deren Brechkraft durch eine Veränderung ihrer Geometrie (z.B. mit Hilfe von Aktuatoren) eingestellt werden kann. Diese adaptiven bzw. einstellbaren optischen Elemente können ggf. mit einer manuellen oder motorischen Veränderung des Abstandes zwischen den optischen Elementen in Strahlrichtung der Laserstrahlung kombiniert werden. Die Fokussiereinrichtung und die Kollimationseinrichtung können aber auch aus starren, nicht in ihrer Geometrie veränderbaren optischen Elementen bestehen, deren relativer Abstand zur Einstellung des Durchmessers des Laserstrahlfokus manuell oder motorisch verändert wird. Die Fokussier- und Kollimationseinrichtung kann auch austauschbare Linsen- und/oder Spiegelelemente mit unterschiedlichen Brennweiten aufweisen, die automatisiert bzw. motorisch, d.h. mit Hilfe von Aktuatoren, oder ggf. manuell ausgetauscht werden, um die Brennweite und somit den Durchmesser des Laserstrahlfokus einzustellen.

Bei einer weiteren Ausführungsform weist der optische Isolator eine Gasdruck-Einstelleinrichtung zur Einstellung eines Gasdrucks des Gases in der Kammer auf. Wie weiter oben beschrieben wurde, beeinflusst der Gasdruck in der Kammer die Plasmazündschwelle. Es hat sich als günstig erwiesen, in der Kammer eine definierte Gasatmosphäre zu erzeugen, welche die Bildung eines Plasmas und eine selektive Filterung der rückreflektierten bzw. in der zweiten Richtung propagierenden Laserstrahlung vereinfacht. Bei dem in der Kammer bzw. in der Gasatmosphäre der Kammer vorhandenen Gas kann es sich beispielsweise um Stickstoff handeln, ggf. aber auch um Helium oder um Argon oder um Mischungen dieser Gase. Der Stickstoff in der Kammer kann beispielsweise einen Druck zwischen ca. 50 mbar und ca. 2 bar aufweisen. Geeignete Druckbereiche für unterschiedliche Gase und für Laserstrahlung bei einer Wellenlänge von 10,6 µm sind beispielsweise dem Artikel "Breakdown thresholds in rare and molecular gases using pulsed 10.6 µm radiation" von G.A. Hill et al., Journal of Physics D, Vol. 5, No. 11, 1972 zu entnehmen.

Bei einer Weiterbildung ist die Gasdruck-Einstelleinrichtung zur Erzeugung einer stehenden akustischen Welle in der Kammer, insbesondere im Bereich des Laserstrahlfokus, ausgebildet. Durch die stehende akustische Welle kann der (lokale) Druck in der Kammer, insbesondere in dem Bereich, in dem das Plasma gezündet werden soll, d.h. typischer Weise an dem Laserstrahlfokus, angepasst werden. Die Gasdruck-Einstelleinrichtung weist in diesem Fall typischer Weise mindestens einen akustischen Wandler auf, z.B. in Form eines Lautsprechers, der elektrische Signale in akustische Signale umwandelt. Wird ein akustischer Wandler verwendet, kann dieser mit einer die von diesem ausgehende akustische Welle reflektierenden Fläche bzw. einem akustischen Reflektor kombiniert werden, um die stehende akustische Welle zu erzeugen. Die stehende akustische Welle kann aber auch durch zwei oder mehr akustische Wandler oder durch eine Kombination aus akustischen Wandlern und reflektierenden Flächen erzeugt werden.

Bei einer weiteren Ausführungsform weist der optische Isolator eine Einrichtung zur Einstellung einer Zusammensetzung des Gases in der Kammer auf. Wie weiter oben beschrieben wurde, kann das Gas in der Kammer beispielsweise Stickstoff oder ein Edelgas, z.B. Helium oder Argon, enthalten. Die Einrichtung dient zur Einstellung der Zusammensetzung bzw. des Mischungsverhältnisses der Bestandteile des Gases, das in der Kammer vorhanden ist bzw. der Kammer zugeführt wird.

Bei einer weiteren Ausführungsform weist die Plasmaerzeugungseinrichtung einen Anregungslaser zur Erzeugung von (gepulster) Anregungs-Laserstrahlung sowie eine Zuführungseinrichtung zur Zuführung der Anregungs-Laserstrahlung in die Kammer zur Aufheizung des Gases in der Kammer, insbesondere im Bereich des Laserstrahlfokus, auf. Wie die Strahlquelle wird auch der Anregungslaser typischer Weise gepulst betrieben und ist in der Regel mit der Strahlquelle synchronisiert, so dass die Anregungs-Laserstrahlung nicht der Kammer zugeführt wird, wenn die in der ersten Richtung propagierende (gepulste) Laserstrahlung durch die Kammer tritt.

Bei einer Weiterbildung ist der Anregungslaser ein Kurzpuls-Laser oder ein Ultrakurzpuls-Laser. Ein Kurzpuls-Laser ist geeignet, Pulse mit Pulsdauern zu erzeugen, die typischer Weise im Bereich von Nano-Sekunden liegen, ein Ultrakurzpuls-Laser ist geeignet, extrem kurze Laserpulse mit Pulsdauern im Bereich von Piko- oder ggf. Femto-Sekunden sowie sehr schnelle Pulsfolgen zu erzeugen. Dies ist günstig, da die Laserpulse der Strahlquelle ebenfalls eine hohe Pulswiederholfrequenz und geringe Pulsdauern aufweisen, so dass die Verwendung von gepulster Anregungs-Laserstrahlung mit Pulsdauern von weniger als ca. 50 Nanosekunden günstig ist.

Der Anregungslaser kann in dem optischen Isolator auf unterschiedliche Weise eingesetzt werden: Beispielsweise kann der Anregungslaser zur Einstellung der Plasmazündschwelle verwendet werden, wenn das Plasma passiv durch die in der zweiten Richtung propagierende bzw. rückreflektierte Laserstrahlung erzeugt wird. In diesem Fall heizt der Anregungslaser typischer Weise das Gas im Bereich des Laserstrahlfokus so stark auf, dass auch bei einem vergleichsweise schwachen Rückreflex, der eine geringe Intensität aufweist, ein Plasma gezündet wird, in dem die rückreflektierte Laserstrahlung absorbiert wird, ohne dass die in der ersten Richtung propagierende Laserstrahlung hierdurch beeinflusst wird.

Alternativ kann die Leistung des Anregungslasers und somit die Intensität der in die Kammer eintretenden Anregungs-Laserstrahlung so weit erhöht werden, dass diese ausreichend ist, um selbst ein Plasma zu zünden, d.h. es wird nicht zusätzlich die Intensität der in der Verstärkeranordnung verstärkten Laserstrahlung benötigt. Das lokal begrenzte Plasma reicht jedoch nicht aus, um den Rückreflex vollständig zu unterdrücken. Ein Teil der Leistung der in der zweiten Richtung propagierenden Laserstrahlung wird aber in dem Plasma absorbiert, was zu einer weiteren Ausdehnung des Plasmas und somit zur Ausbildung der vollen Filterleistung durch das Plasma führt.

Alternativ kann die Leistung des Anregungslasers und somit die Intensität der Anregungs-Laserstrahlung in der Kammer so weit erhöht werden, dass diese ein Plasma zündet, welches eine ausreichende Ausdehnung aufweist, um den Rückreflex vollständig zu absorbieren oder zu reflektieren.

Bei einer Weiterbildung weist die Zuführungseinrichtung eine Fokussieroptik zur Fokussierung der Anregungs-Laserstrahlung in der Kammer auf. Die Fokussieroptik kann insbesondere dazu dienen, die Anregungs-Laserstrahlung an den Laserstrahlfokus der in der ersten Richtung propagierenden Laserstrahlung zu fokussieren und auf diese Weise eine ausreichende Intensität für die Zündung des Plasmas zu erzeugen, dies ist aber nicht zwingend erforderlich, wie nachfolgend beschrieben wird.

Bei einer weiteren Weiterbildung ist in der Kammer eine Blende angeordnet, durch deren Blendenöffnung die in der ersten Richtung propagierende Laserstrahlung hindurch tritt, wobei eine Seite der Blende eine reflektierende Fokussieroptik zur Fokussierung der Anregungs-Laserstrahlung bildet. Bei der Blende handelt es sich typischer Weise um eine Raumblende, z.B. aus Kupfer, die mittig zur Strahlachse der Laserstrahlung ausgerichtet ist. Das Material der Blende oder ggf. das Material einer auf die Blende zur Reflexion der Anregungs-Laserstrahlung aufgebrachten Beschichtung ist auf die Wellenlänge der Anregungs-Laserstrahlung abgestimmt. Beispielsweise ermöglicht eine Blende aus Kupfer oder eine auf die Seite der Blende aufgebrachte reflektierende Beschichtung z.B. aus Gold die Reflektion von Anregungs-Laserstrahlung, die bei Wellenlängen von z.B. ca. 1030 nm liegt. Die Verwendung von Aluminium als Material der Blende bzw. der Beschichtung ermöglicht die Reflexion von Anregungs-Laserstrahlung, die im sichtbaren Wellenlängenbereich liegt.

Der Laserstrahlfokus der von der Strahlquelle erzeugten Laserstrahlung befindet sich typischer Weise im Bereich der Blendenöffnung. Die Blende, genauer gesagt eine Seite der Blende, weist typischer Weise mindestens einen konischen Abschnitt bzw. eine konische Fläche auf, der bzw. die dazu genutzt werden kann, die Anregungs-Laserstrahlung in Richtung auf die Strahlachse der Laserstrahlung zu fokussieren. Die an einem konischen Abschnitt der Blende reflektierte Anregungs-Laserstrahlung bildet typischer Weise einen Quasi-Bessel-Strahl, der eine langgezogene Fokuszone aufweist, die entlang der Mittenachse der Blende konvergiert und die bezüglich der Strahlachse der durch die Blende tretenden Laserstrahlung justiert ist. Die Blende ist typischer Weise rotationssymmetrisch zu ihrer Mittenachse ausgebildet, und so justiert, dass die Mittenachse der Blende mit der Strahlachse der Laserstrahlung übereinstimmt. Durch die langgezogene Fokuszone wird der Bereich verlängert, in dem die Anregungs-Laserstrahlung mit der durch die Blende tretenden Laserstrahlung zur Bildung eines Plasmas wechselwirken kann.

Bei einer Weiterbildung ist die Zuführungseinrichtung ausgebildet, die Anregungs-Laserstrahlung in Form eines die Blendenöffnung aussparenden Hohlstrahls auf die bevorzugt der Strahlquelle abgewandte Seite der Blende einzustrahlen. Die Anregungs-Laserstrahlung wird an der typischer Weise in radialer Richtung konisch verlaufenden Seite der Blende reflektiert und zur Mittenachse der Blende hin fokussiert. Durch die Verwendung des Hohlstrahls tritt die Anregungs-Laserstrahlung nicht durch die Blendenöffnung, so dass diese nicht in die Verstärkeranordnung gelangt und dort zu Schäden führen kann. Zur Erzeugung eines Hohlstrahls, d.h. von Anregungs-Laserstrahlung mit einem rotationssymmetrischen Strahlprofil mit einem zentralen Bereich, der keine bzw. nur eine geringe Intensität aufweist, kann die Zuführungseinrichtung beispielsweise ein Axicon aufweisen, welches typischer Weise zwei konisch geformte Flächen aufweist. Die konisch geformten Flächen können in der Art eines Teleskops verschoben bzw. in ihrem Abstand zueinander verändert werden, um das Strahlprofil geeignet anzupassen.

Bei einer weiteren Ausführungsform weist die Treiberlaseranordnung eine Steuerungseinrichtung auf, die ausgebildet ist, den Anregungslaser zur Erzeugung der Anregungs-Laserstrahlung für die Zündung eines Plasmas in dem Gas der Kammer auch zwischen dem Austritt der in der ersten Richtung propagierenden Laserstrahlung aus der Kammer und dem Eintritt der in der zweiten Richtung propagierenden Laserstrahlung in die Kammer anzusteuern. Die Steuerungseinrichtung kann alternativ oder zusätzlich den Anregungslaser auch nach der Unterdrückung der in der zweiten Richtung propagierenden Laserstrahlung und vor weiterer in die Kammer eintretender, in der ersten Richtung propagierenden Laserstrahlung (d.h. einem nachfolgenden Laserpuls) für die Zündung eines Plasmas in dem Gas der Kammer ansteuern. Insbesondere kann in der Kammer dauerhaft ein Plasma gezündet werden, wobei lediglich die Zeitdauer, in der die in der ersten Richtung propagierende Laserstrahlung die Kammer durchquert, von der Erzeugung des Plasmas ausgenommen wird.

Durch die Zündung des Plasmas in der Kammer auch in Zeiträumen, in denen die in der zweiten Richtung propagierende Laserstrahlung nicht die Kammer durchläuft, kann mit Hilfe des optischen Isolators eine weitgehend vollständige optische Entkopplung (=Güteschaltung) erfolgen. Ist der optische Isolator in diesem Fall zwischen zwei optischen Verstärkern der Verstärkeranordnung angeordnet, werden diese optisch voneinander isoliert, so dass kein parasitärer Laservorgang, d.h. kein Self-Lasing, auftreten kann.

Bei einer Weiterbildung umfasst die Treiberlaseranordnung ein schaltbares Element zur Selektion von Pulsen der Anregungs-Laserstrahlung. Ein solches schaltbares Element kann beispielsweise in den Strahlengang der Zuführungseinrichtung zwischen dem Anregungslaser und der Kammer angeordnet werden, um gezielt einzelne Anregungs-Laserpulse auszuwählen ("pulse picking"). Die Auswahl von Pulsen der Anregungs-Laserstrahlung erfolgt typischer Weise durch die Unterdrückung von nicht benötigten bzw. unerwünschten Pulsen der Anregungs-Laserstrahlung, um auf diese Weise eine gewünschte Pulsfolge zu erzeugen. Das schaltbare Element, beispielsweise in Form eines elektro-optischen oder akustooptischen Modulators, kann auch in den Anregungslaser integriert sein, um gezielt einzelne Anregungs-Laserpulse zu selektieren ("cavity dumping"). In beiden Fällen sollte das schaltbare Element mit der Strahlquelle, genauer gesagt mit den Laserpulsen der Strahlquelle, synchronisiert sein.

Bei einer weiteren Ausführungsform umfasst die Treiberlaseranordnung mindestens zwei optische Isolatoren und die Zuführungseinrichtung weist mindestens einen Strahlteiler zur Aufteilung der Anregungs-Laserstrahlung auf die zwei optischen Isolatoren bzw. auf jeweilige Kammern der optischen Isolatoren auf. Durch die Verwendung von zwei oder mehr optischen Isolatoren an unterschiedlichen Stellen der Verstärkeranordnung kann die maximale Unterdrückung von Rückreflexen bzw. die maximale Unterdrückung von Self-Lasing erreicht werden. Um nicht für jeden optischen Isolator einen eigenen Anregungslaser verwenden zu müssen, kann die Anregungs-Laserstrahlung, genauer gesagt deren Leistung, an mindestens einem Strahlteiler auf zwei oder mehr optische Isolatoren aufgeteilt werden.

Bei einer Weiterbildung weist die Zuführungseinrichtung mindestens eine Verzögerungsstrecke zur Verzögerung der Anregungs-Laserstrahlung vor der Zuführung zu mindestens einem optischen Isolator auf. Durch die mindestens eine Verzögerungsstrecke kann die Anregungs-Laserstrahlung zeitlich so angepasst werden, dass diese die jeweilige Kammer zumindest zu dem Zeitpunkt bzw. während derjenigen Zeitspanne erreicht, in der auch die in der zweiten Richtung propagierende Laserstrahlung in die Kammer eintritt, um deren Durchtritt durch die Kammer zu verhindern bzw. um diese möglichst stark abzuschwächen. Die von der jeweiligen Verzögerungsstrecke erzeugte Verzögerung ist geeignet an die von der Strahlquelle erzeugte Pulsfolge der gepulsten Laserstrahlung angepasst.

Die Erfindung betrifft auch eine EUV-Strahlungserzeugungsvorrichtung, umfassend: eine Treiberlaseranordnung wie weiter oben beschrieben, eine Vakuum-Kammer, in der ein Target-Material anordenbar ist, sowie eine Strahlführungseinrichtung zur Führung der in der ersten Richtung propagierenden Laserstrahlung von der Treiberlasereinrichtung zu dem Target-Material. Wie weiter oben beschrieben wurde, trifft die (gepulste) Laserstrahlung, welche in der ersten Richtung propagiert, auf das Target-Material, z.B. in Form von Zinn-Tröpfchen, und wird an diesem teilweise reflektiert. Die an dem Target-Material zurück reflektierte Laserstrahlung propagiert in der zweiten Richtung entlang der Strahlführungseinrichtung, durchläuft erneut die Verstärkeranordnung und wird an dem mindestens einen optischen Isolator durch die weiter oben beschriebene Zündung eines Plasmas in der Kammer gefiltert, so dass diese nicht zur Strahlquelle zurück gelangen kann.

Es versteht sich, dass der weiter oben beschriebene optische Isolator bzw. der Plasmaschalter auch in anderen optischen Systemen als in einer EUV-Strahlungserzeugungsvorrichtung bzw. in einer Treiberlaseranordnung verwendet werden kann, beispielsweise bei optischen Systemen wie gepulsten Festkörperlasern bzw. Festkörperverstärkern oder dergleichen. Insbesondere kann ein solcher optischer Isolator einen Anregungslaser aufweisen, der wie weiter oben im Zusammenhang mit der Treiberlaseranordnung beschrieben ausgebildet ist und die Anregungs-Laserstrahlung z.B. mittels einer Blende fokussieren, wie dies weiter oben beschrieben ist.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine EUV-Strahlungserzeugungsvorrichtung mit einer Treiberlaseranordnung, die einen optischen Isolator mit einer mit einem Gas gefüllten Kammer sowie eine Plasmaerzeugungseinrichtung zur Zündung eines Plasmas in der Kammer aufweist,
- Fig. 2: schematische Darstellungen von gepulster Laserstrahlung, die in dem optischen Isolator von Fig. 1 in einer ersten Richtung und in einer zweiten Richtung durch eine Fokussier- und Kollimationseinrichtung propagiert, welche eine passive Plasmaerzeugungseinrichtung bildet,
- Fig. 3a,b: Darstellungen einer Fokussier- und Kollimationseinrichtung mit vier bzw. mit drei Linsen mit einstellbarer Brennweite zur Einstellung eines Fokusdurchmessers der Laserstrahlung,
- Fig. 4: zwei Darstellungen analog zu Fig. 2 mit einer Einrichtung zur Erzeugung einer stehenden akustischen Welle in der Kammer im Bereich eines Laserstrahlfokus,
- Fig. 5: eine weitere Darstellung einer EUV-Strahlungserzeugungsvorrichtung, die eine Treiberlaseranordnung mit drei optischen Isolatoren und mit einem Anregungslaser als aktiver Plasmaerzeugungseinrichtung zur Zündung eines Plasmas in dem Gas der Kammer eines jeweiligen optischen Isolators aufweist,
- Fig. 6: zwei Darstellungen eines der optischen Isolatoren von Fig. 5, bei denen gepulste Anregungs-Laserstrahlung des Anregungslasers ein Plasma zündet, und
- Fig. 7: eine Darstellung analog zu Fig. 6, bei welcher die gepulste Anregungs-Laserstrahlung des Anregungslasers an einer Seite einer Blende reflektiert und fokussiert wird.

In der folgenden Beschreibung der Zeichnungen werden für gleiche bzw. funktionsgleiche Bauteile identische Bezugszeichen verwendet.

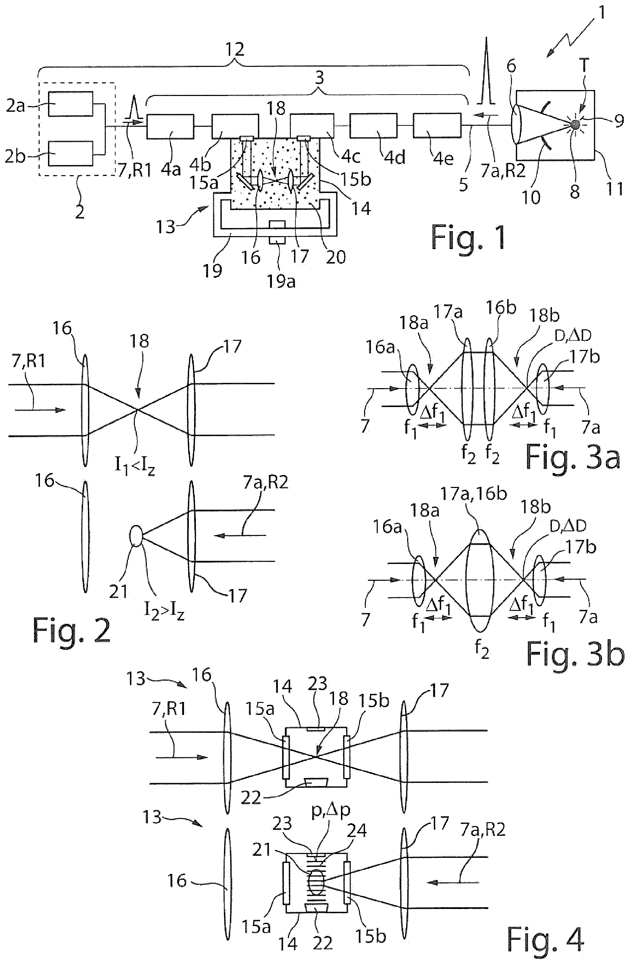

**Fig. 1** zeigt eine EUV-Strahlungserzeugungsvorrichtung 1, die eine Strahlquelle 2, eine Verstärkeranordnung 3 mit fünf optischen Verstärkern 4a-e, eine nicht näher dargestellte Strahlführungseinrichtung 5 sowie eine Fokussieroptik 6 aufweist, die zur Vereinfachung der Darstellung als Fokussierlinse dargestellt ist, aber auch eines oder mehrere reflektierende optische Elemente aufweisen kann. Die Fokussieroptik 6 dient dazu, einen von der Strahlquelle 2 erzeugten und von der Verstärkeranordnung 3 verstärkten Laserpuls 7 (d.h. gepulste Laserstrahlung) an einem Zielbereich bzw. einer Zielposition T zu fokussieren, an der ein Target-Material 8 eingebracht ist. Das Target-Material 8 geht bei der Bestrahlung mit den Laserpulsen 7 in einen Plasma-Zustand über und emittiert EUV-Strahlung 9, die mittels eines Kollektorspiegels 10 fokussiert wird. Bei dem in Fig. 1 gezeigten Beispiel weist der Kollektorspiegel 10 eine Öffnung zum Durchtritt der Laserpulse 7 auf und die Fokussieroptik 6 trennt eine Vakuum-Kammer 11, in der das Target-Material 8 angeordnet ist, von der Strahlführungseinrichtung 5.

Die Strahlquelle 2 ist bei dem in Fig. 1 gezeigten Beispiel als CO₂-Laserquelle ausgebildet und weist einen ersten und zweiten CO₂-Laser 2a, 2b auf, die zur Erzeugung eines Vor-Pulses und eines zeitlich kurz auf den Vor-Puls folgenden Haupt-Pulses dienen, der eine höhere Intensität als der Vor-Puls aufweisen kann. Der von dem ersten CO₂-Laser 2a erzeugte Vor-Puls und der von dem zweiten CO₂-Laser 2b erzeugte Haupt-Puls werden zu einem gemeinsamen Strahlweg zusammengeführt und bilden die weiter oben beschriebene gepulste Laserstrahlung 7, die aus der Strahlquelle 2 austritt. Gegebenenfalls können der Vor-Puls und der Haupt-Puls unterschiedliche Wellenlängen aufweisen, im gezeigten Beispiel weist die gepulste Laserstrahlung 7 jedoch nur eine einzige Wellenlänge von ca. 10,6 µm auf. Die Strahlquelle 2 bildet gemeinsam mit der Verstärkeranordnung 3 eine Treiberlaseranordnung 12 der EUV-Strahlungserzeugungsvorrichtung 1.

Nachdem die von der Strahlquelle 2 kommende, in einer ersten Richtung R1 propagierende Laserstrahlung 7 auf das an der Zielposition T angeordnete Target-Material 8 trifft, wird ein Teil der auftreffenden Laserstrahlung 7 von dem Target-Material 8 in eine zweiten, der ersten entgegen gesetzte Richtung R2 zurück reflektiert. Die rückreflektierte Laserstrahlung 7a durchläuft die Strahlführungseinrichtung 5 und trifft erneut auf die Verstärkeranordnung 3, in der die rückreflektierte Laserstrahlung 7a verstärkt wird. Um zu verhindern, dass die rückreflektierte Laserstrahlung 7a zur Strahlquelle 2 gelangt bzw. so stark verstärkt wird, dass diese optische Bauelemente beschädigt, ist bei der in Fig. 1 gezeigten Verstärkeranordnung 3 zwischen dem zweiten optischen Verstärker 4b und dem dritten optischen Verstärker 4c ein optischer Isolator 13 angebracht.

Der optische Isolator 13 weist eine Kammer 14 auf, die ein Eintrittsfenster 15a zum Eintritt der in der ersten Richtung R1 propagierenden, gepulsten Laserstrahlung 7 von dem zweiten optischen Verstärker 4b und ein Austrittsfenster 15b zum Austritt der in der ersten Richtung R1 propagierenden Laserstrahlung 7 aus der Kammer 14 und zum Eintritt in den dritten optischen Verstärker 4c aufweist. Das Eintrittsfenster 15a der Kammer 14 fällt im gezeigten Beispiel mit dem Austrittsfenster des zweiten optischen Verstärkers 4b zusammen. Ebenso fällt das Austrittsfenster 15b der Kammer 14 mit dem Eintrittsfenster des dritten optischen Verstärkers 4c der Verstärkeranordnung 3 zusammen. Es versteht sich, dass anders als in Fig. 1 gezeigt ist, die Kammer 14 auch als von dem zweiten Verstärker 4b und dem dritten Verstärker 4c räumlich getrennte Baueinheit ausgebildet sein kann.

Bei dem in Fig. 1 gezeigten Beispiel wird die kollimierte gepulste Laserstrahlung 7 von einer Fokussiereinrichtung 16 in Form einer ersten Linse auf einen Laserstrahlfokus 18 in der Kammer 14 fokussiert. Die von dem Laserstrahlfokus 18 (Zwischenfokus) ausgehende Laserstrahlung 7 wird von einer Kollimationseinrichtung 17 in Form einer weiteren Linse kollimiert, bevor diese durch das Austrittsfenster 15b aus der Kammer 14 austritt und in den dritten optischen Verstärker 4c eintritt.

Die Kammer 14 ist mit einem Gaskreislauf 19 verbunden, der in der Kammer 14 eine definierte Gasatmosphäre eines in der Kammer 14 befindlichen Gases 20 erzeugt. Bei dem in Fig. 1 gezeigten Beispiel wird der Kammer 14 das Gas 20, beispielsweise Stickstoff, ggf. Helium oder Argon, an einem Gaseintritt zugeführt und an einem Gasaustritt wieder aus der Kammer 14 abgeführt. Das in der Kammer 14 befindliche Gas 20 dient dazu, ein in **Fig. 2** gezeigtes Plasma 21 in der Kammer 14 zu erzeugen, um die in der zweiten Richtung R2 propagierende Laserstrahlung 7a zu unterdrücken, wie weiter unten in Zusammenhang mit Fig. 2 näher beschrieben wird.

Der in Fig. 1 gezeigte Gaskreislauf 19 kann beispielsweise ein Turboradialgebläse mit Gaskühler aufweisen, um das aus der Kammer 14 ausströmende Gas 20, welches sich bei der Plasmabildung aufgrund der Absorption der Laserstrahlung 7a erwärmt, vor der Rückführung in die Kammer 14 abzukühlen. Es versteht sich, dass auch andere Arten von Gaskühlern, beispielsweise in Form von Wärmetauschern, zur Kühlung des Gases 20 verwendet werden können. Anders als in Fig. 1 gezeigt ist, kann das Gas 20 im Wesentlichen quer zur Strahlrichtung der Laserstrahlung 7 durch die Kammer 14 strömen.

In Fig. 2 ist ein Detail der Kammer 14 mit der Fokussiereinrichtung 16 und der Kollimationseinrichtung 17 sowie dem Laserstrahlfokus 18 dargestellt. Fig. 2 zeigt oben die in der ersten Richtung R1 propagierende Laserstrahlung 7, welche an dem Laserstrahlfokus 18 eine (maximale) Intensität I₁ aufweist, die kleiner ist als eine Plasmazündschwelle I_{Z} (Intensitäts-Schwellwert), um in dem in der Kammer 14 befindlichen Gas 20 direkt das Plasma 21 zu zünden.

In Fig. 2 unten ist die in der zweiten Richtung R2 propagierende Laserstrahlung 7a dargestellt, welche in der Kammer 14, genauer gesagt am Laserstrahlfokus 18, eine Intensität I₂ aufweist, die größer ist als die Plasmazündschwelle I_{Z}, so dass die in der zweiten Richtung R2 propagierende Laserstrahlung 7a ein Plasma 21 in dem Gas 20 der Kammer 14 zündet. Die in der zweiten Richtung R2 propagierende Laserstrahlung 7a wird an dem Plasma 21 absorbiert, reflektiert und/oder gebrochen, so dass die in der zweiten Richtung R2 propagierende Laserstrahlung 7a sich selbst auslöscht, d.h. keine oder nur ein sehr geringer Anteil der in der zweiten Richtung R2 propagierenden Laserstrahlung 7 verlässt die Kammer 14 durch das Eintrittsfenster 15a. Die Fokussiereinrichtung 16 und die Kollimationseinrichtung 17 bilden zusammen eine passive Plasmaerzeugungseinrichtung 16, 17, die zur gepulsten Zündung des Plasmas 21 in dem Gas 20 der Kammer 14 ausgebildet ist.

Da die Intensität I₂ der an dem Target-Material T zurück reflektierten, in der zweiten Richtung R2 propagierenden Laserstrahlung 7a und ggf. auch die Intensität I₁ der in der ersten Richtung R1 propagierenden Laserstrahlung 7 in Abhängigkeit von den Umgebungsbedingungen ggf. variiert, hat es sich als günstig erwiesen, wenn der optische Isolator 13 ausgebildet ist, die Plasmazündschwelle I_{Z} in dem Gas 20 der Kammer 14 einzustellen.

Zu diesem Zweck kann beispielsweise eine Einrichtung 19a zur Einstellung der Zusammensetzung des Gases 20 in der Kammer 14 dienen, die in den Gaskreislauf 19 integriert ist, um die Gasbestandteile des Gases 20 geeignet zu mischen, beispielsweise um das Verhältnis zwischen Stickstoff und einem Edelgas einzustellen, die als Gas 20 bzw. als Gasgemisch der Kammer 14 zugeführt werden. Die Zusammensetzung des Gases 20 beeinflusst die Plasmazündschwelle I_{Z} in der Kammer 14, so dass die Plasmazündschwelle I_{Z} mittels der Einrichtung 19a eingestellt werden kann.

Zur Einstellung der Plasmazündschwelle I_{Z} kann aber beispielsweise auch die in **Fig. 3a,b** gezeigte optische Anordnung verwendet werden, welche eine erste Fokussierlinse 16a zur Fokussierung der in der ersten Richtung R1 propagierenden Laserstrahlung 7 auf einen ersten Laserstrahlfokus 18a sowie eine erste Kollimationslinse 17a zur Kollimation der von dem ersten Laserstrahlfokus 18a ausgehenden Laserstrahlung 7 sowie eine zweite Fokussierlinse 16b zur Fokussierung der kollimierten Laserstrahlung 7 auf einen zweiten Laserstrahlfokus 18b umfasst. Die divergente Laserstrahlung 7, die von dem zweiten Laserstrahlfokus 18b ausgeht, wird von einer zweiten Kollimationslinse 17b erneut kollimiert. Die beiden Fokussierlinsen 16a,b bilden somit eine Fokussiereinrichtung, die beiden Kollimationslinsen 17a,b eine Kollimationseinrichtung für die in der ersten Richtung R1 propagierende Laserstrahlung 7.

Die erste und zweite Fokussierlinse 16a,b weisen jeweils eine erste (nominelle) Brennweite f₁ auf und die erste und zweite Kollimationslinse 17a,b weisen jeweils eine zweite (nominelle) Brennweite f₂ auf. Die erste Fokussierlinse 16a und die erste Kollimationslinse 17a sind im Abstand der Summe ihrer Brennweiten f₁ + f₂ voneinander angeordnet, d.h. diese bilden ein Strahlteleskop. Gleiches gilt für die zweite Fokussierlinse 16b und die zweite Kollimationslinse 17b, die ebenfalls ein Strahlteleskop bilden. Sowohl die Fokussierlinsen 16a,b als auch die Kollimationslinsen 17a,b weisen eine (in gewissen Grenzen) einstellbare Brennweite f₁, f₂ auf, d.h. es handelt sich um adaptive optische Elemente, deren Geometrie mittels geeigneter Aktuatoren verändert werden kann, beispielsweise um die erste Brennweite f₁ der Fokussierlinsen 16a,b um einen Betrag Δf₁ zu ändern. Bei einer solchen Änderung wird mit Hilfe der Aktuatoren gleichzeitig auch die zweite Brennweite f₂ der Kollimationslinsen 17a,b entsprechend angepasst, so dass der Abstand zwischen einer jeweiligen Fokussierlinse 16a,b und der zugehörigen Kollimationslinse 17a,b der Summe der (geänderten) Brennweiten f₁ + f₂ entspricht.

Wie in Fig. 3a,b gut zu erkennen ist, vergrößert das erste Strahlteleskop den Durchmesser der Laserstrahlung 7, wobei der Abbildungsmaßstab der Vergrößerung vom Quotienten der Brennweiten f₁ / f₂ abhängig ist. Eine Änderung der Brennweiten f₁, f₂ führt somit zu einer Änderung im Abbildungsmaßstab der beiden Strahlteleskope, die eine Änderung ΔD des Durchmessers D der Laserstrahlung 7 im ersten Laserstrahlfokus 18a bzw. im zweiten Laserstrahlfokus 18b zur Folge hat. Verringert sich der Durchmesser D der Laserstrahlung 7, erhöht sich die Intensität I₁ der in der ersten Richtung R1 bzw. die Intensität I₂ der in der zweiten Richtung R2 propagierenden Laserstrahlung 7, 7a am jeweiligen Laserstrahlfokus 18a,b. Erhöht sich der Durchmesser D, nimmt die Intensität I₁ der in der ersten Richtung R1 bzw. die Intensität I₂ der in der zweiten Richtung R2 propagierenden Laserstrahlung 7, 7a am jeweiligen Laserstrahlfokus 18a,b ab. Auf diese Weise kann die Plasmazündschwelle I_{Z} eingestellt werden, ohne dass hierbei die Intensität I₁ der durch das Eintrittsfenster 15a in die Kammer 14 eintretenden, in der ersten Richtung R1 propagierenden Laserstrahlung 7 oder die Intensität I₂ der durch das Austrittsfenster 15b in die Kammer 14 eintretenden Laserstrahlung 7a sich verändert.

Das in Fig. 3b gezeigte Beispiel unterscheidet sich von dem in Fig. 3a gezeigten Beispiel lediglich dadurch, dass die erste Kollimationslinse 17a und die zweite Fokussierlinse 16b in einem gemeinsamen Linsenelement 17a, 16b mit (einstellbarer) Brennweite f₂ vereinigt sind, so dass lediglich drei adaptive optische Elemente für die Einstellung des Durchmessers D des Laserstrahlfokus 18a, 18b benötigt werden.

Bei den in Fig. 3a,b gezeigten Beispielen ist es möglich, mindestens eine, ggf. alle Fokussierlinsen 16a,b und/oder Kollimationslinsen 17a,b im Strahlengang der Laserstrahlung 7, 7a mittels geeigneter Aktuatoren verschiebbar anzuordnen, d.h. diese optischen Elemente müssen nicht zwingend adaptiv ausgebildet sein, um den Durchmesser D der Laserstrahlung 7, 7a einzustellen. An Stelle von adaptiven Fokussierlinsen 16a,b bzw. Kollimationslinsen 17a,b ist es auch möglich, mehrere Fokussierlinsen 16a,b bzw. Kollimationslinsen 17a,b mit unterschiedlichen Brennweiten zu verwenden, die zur Einstellung des Durchmessers D der Laserstrahlung 7, 7a manuell oder ggf. unter Verwendung von Aktuatoren und mit Hilfe einer geeigneten Steuerungseinrichtung der Treiberlaseranordnung 12 ausgetauscht werden können. An Stelle der Verwendung von transmittierenden optischen Elementen in Form von Linsen kann die Kollimation bzw. die Fokussierung der Laserstrahlung 7, 7a auch ganz oder teilweise mit Hilfe von reflektierenden optischen Elementen, beispielsweise in Form von Parabolspiegeln, vorgenommen werden.

Fig. 4 zeigt einen optischen Isolator 13, der wie der in Fig. 1 dargestellte optische Isolator 13 aufgebaut ist, d.h. eine Fokussierlinse 16 und eine Kollimationslinse 17 aufweist, die - anders als in Fig. 1 gezeigt ist - außerhalb der Kammer 14 angeordnet sind, um die Kammer 14 bzw. den mit dem Gas 20 gefüllten Innenraum der Kammer 14 möglichst klein dimensionieren zu können. Die Kammer 14 des optischen Isolators 13 von Fig. 4 schließt im Gegensatz zu dem optischen Isolator 13 von Fig. 1 nicht unmittelbar an den zweiten Verstärker 4b bzw. an den dritten Verstärker 4c an, sondern ist im frei propagierenden Strahlengang der Laserstrahlung 7, 7a zwischen dem zweiten optischen Verstärker 4b und dem dritten optischen Verstärker 4c angeordnet.

In der Kammer 14 des in Fig. 4 gezeigten optischen Isolators 13 ist ein Lautsprecher 22 angeordnet, der mittels einer Steuerungseinrichtung der Treiberlaseranordnung 12 angesteuert wird, um in dem Gas 20 der Kammer 14 eine stehende akustische Welle 24 zu erzeugen. Zu diesem Zweck ist an einer dem Lautsprecher 22 gegenüber liegenden Wand der Kammer 14 ein akustischer Reflektor 23 angeordnet, der die von dem Lautsprecher 22 erzeugte akustische Welle zu diesem zurückreflektiert, so dass sich die stehende akustische Welle 24 in der Kammer 14 ausbildet. Die Intensität der stehenden akustischen Welle 24 in der Kammer 14 kann eingestellt werden, wodurch sich der Gasdruck p des Gases 20 in der Kammer 14, genauer gesagt an dem Laserstrahlfokus 18, um einen Betrag Δp verändert, so dass der Lautsprecher 22 gemeinsam mit dem Reflektor 23 als Einrichtung zur Einstellung der Plasmazündschwelle I_{Z} zur Zündung des Plasmas 21 in dem Gas 20 der Kammer 14 dient. Auch die Kammer 14 des in Fig. 4 gezeigten optischen Isolators 13 weist einen Gaskreislauf 19 auf, auf dessen Darstellung in Fig. 4 aus Gründen der Übersichtlichkeit verzichtet wurde. Die Kammer 14 bzw. der Gaskreislauf 19 kann ggf. eine nicht bildlich dargestellte Drucksteuer- bzw. Druckregeleinrichtung aufweisen, um in der Kammer 14 einen (statischen) Gasdruck p einzustellen, der eine Plasmabildung in der Kammer 25 begünstigt.

Um eine maximale Unterdrückung der in der zweiten Richtung R2 propagierenden Laserstrahlung 7a zu erzeugen, können weitere optische Isolatoren in der EUV-Strahlungserzeugungsvorrichtung 1 von Fig. 1 angeordnet sein. Typischer Weise sind die optischen Isolatoren 13 nicht am Ende der Verstärkeranordnung 3, beispielsweise nach dem letzten Verstärker 4e, angeordnet, sondern am Anfang der Verstärkerkette 3, d.h. beispielsweise vor dem ersten Verstärker 4a, vor dem zweiten Verstärker 4b oder vor dem dritten Verstärker 4c, da an diesen Stellen der Verstärkeranordnung 3 typischer Weise die Intensität I₁ der in der ersten Richtung R1 propagierenden Laserstrahlung 7 größer ist als die Intensität I₂ der in der zweiten Richtung R2 propagierende Laserstrahlung 7a, so dass bei geeignet eingestellter Plasmazündschwelle I_{Z} nur die in der zweiten Richtung R2 propagierende Laserstrahlung 7a, aber nicht die in der ersten Richtung R1 propagierende Laserstrahlung 7 ein Plasma 21 in der Kammer 14 zündet.

Für die passive Erzeugung des Plasmas 21 in dem Gas 20 der Kammer 14 ist es nicht erforderlich, Laserstrahlung 7, 7a mit der Wellenlänge eines CO₂-Lasers 2a, 2b zu verwenden, vielmehr kann auch Laserstrahlung 7, 7a, welche z.B. von einem Festkörperlaser erzeugt wird und eine geringere Wellenlänge von beispielsweise 1,06 µm aufweist, unter geeigneten Bedingungen in dem Gas 20 der Kammer 14 ein Plasma 21 erzeugen.

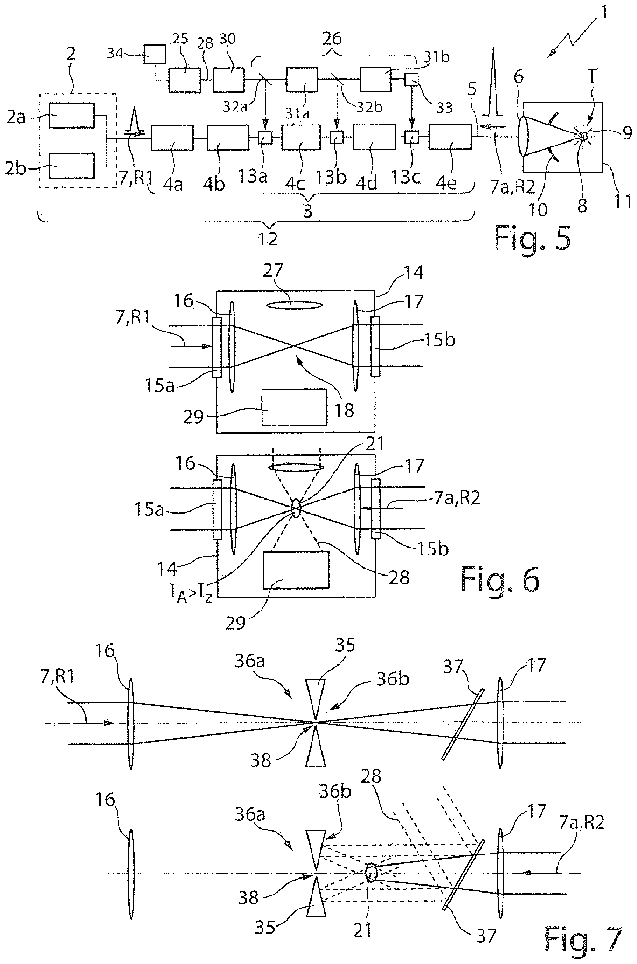

Fig. 5 zeigt eine EUV-Strahlungserzeugungsvorrichtung 1, die sich von der in Fig. 1 gezeigten EUV-Strahlungserzeugungsvorrichtung 1 im Wesentlichen dadurch unterscheidet, dass an Stelle eines optischen Isolators 13, der eine passive Plasmaerzeugungseinrichtung in Form der Fokussier- und Kollimationseinrichtungen 16, 17 aufweist, drei optische Isolatoren 13a-c in der Verstärkeranordnung 3 angeordnet sind, bei denen die Bildung eines Plasmas 21 in der Kammer 14 jeweils aktiv mittels eines Anregungslasers 25 vorgenommen wird, der im gezeigten Beispiel als Ultrakurzpuls-Laser ausgebildet ist.

Die von dem Anregungslaser 25 erzeugte Anregungs-Laserstrahiung 28 wird den optischen Isolatoren 13a-c über eine Zuführungseinrichtung 26 zugeführt, die bei dem in Fig. 5 gezeigten Beispiel einen ersten Strahlteiler 32a zur Aufteilung der Leistung der von dem Anregungslaser 25 erzeugten Anregungs-Laserstrahiung 28 auf einen ersten Anteil aufgeteilt wird, welcher dem ersten optischen Isolator 13a zugeführt wird, sowie auf einen zweiten Anteil, welcher einer ersten Verzögerungsstrecke 31 a zugeführt wird. Die Anregungs-Laserstrahlung 28, welche die erste Verzögerungsstrecke 31a verlässt, wird an einem zweiten Strahlteiler 32b in einen ersten Anteil aufgeteilt, der dem zweiten optischen Isolator 13b zugeführt wird, und in einen zweiten Anteil, der einer zweiten Verzögerungsstrecke 31b zugeführt wird. Die Anregungs-Laserstrahlung 28, welche die zweite Verzögerungsstrecke 31b verlässt, wird über eine Strahlumlenkeinrichtung 33 (Umlenkspiegel) dem dritten optischen Isolator 13c zugeführt. Die beiden Verzögerungsstrecken 31a, 31b ermöglichen es, die von dem Anregungslaser 25 erzeugte Anregungs-Laserstrahlung 28 mit der gepulsten Laserstrahlung 7 bzw. 7a zu synchronisieren, die von der Strahlquelle 2 erzeugt wird.

Die Synchronisation erfolgt auf eine solche Weise, dass die Anregungs-Laserstrahlung 28 in der Kammer 14 eines jeweiligen optischen Isolators 13a-c eintritt und dort ein Plasma 21 erzeugt, während bzw. unmittelbar bevor die in der zweiten Richtung R2 propagierende Laserstrahlung 7a in die Kammer 14 eintritt, wie dies in Fig. 6 unten dargestellt ist. Während die in der ersten Richtung R1 propagierende Laserstrahlung 7 die Kammer 14 durchquert, wird jedoch keine Anregungs-Laserstrahlung 28 in die Kammer 14 eingestrahlt, so dass die Plasmaschwelle I_{Z} nicht überschritten wird und die in der ersten Richtung R1 propagierende Laserstrahlung 7 die Kammer 14 ungehindert passieren kann (vgl. Fig. 6 oben).

Für die Synchronisation bzw. für die Selektion von Pulsen der Anregungs-Laserstrahlung 28 ist zwischen dem Anregungslaser 25 und der Zuführungseinrichtung 26 ein schaltbares Element 30 angeordnet. Das schaltbare Element 30 kann z.B. in Form eines Choppers ausgebildet sein, um gezielt einzelne Pulse der Anregungs-Laserstrahiung 28 zu unterdrücken. Die Synchronisation des schaltbaren Elements 30 mit der gepulsten Laserstrahlung 7, 7a der Strahlquelle 2 erfolgt im gezeigten Beispiel durch eine Steuerungseinrichtung 34, die mit dem Anregungslaser 25, dem schaltbaren Element 30 und der Strahlquelle 2 in Signal-Verbindung steht.

Um in der Kammer 14 eine Intensität I_{A} der Anregungs-Laserstrahlung 28 zu erzeugen, welche die Plasmazündschwelle I_{Z} zur Zündung des Plasmas 21 überschreitet, weist die Zuführungseinrichtung 26 eine in Fig. 6 gezeigte Fokussieroptik 27 in Form einer Linse auf. Die Fokussieroptik 27 fokussiert die Anregungs-Laserstrahlung 28 auf den Laserstrahlfokus 18 der von der Strahlquelle 2 erzeugten Laserstrahlung 7, um dort das Plasma 21 zu erzeugen und die in der zweiten Richtung R2 propagierende Laserstrahlung 7a zu absorbieren und/oder zu reflektieren und somit am Durchtritt durch die Kammer 14 zu hindern. Wie in Fig. 6 ebenfalls zu erkennen ist, wird ein Teil der Anregungs-Laserstrahlung 28, der nicht zur Anregung bzw. zur Aufrechterhaltung des Plasmas 21 beiträgt, in einer Strahlfalle 29 aufgefangen.

**Fig. 7** zeigt eine alternative Möglichkeit, die Anregungs-Laserstrahlung 28 zur Erzeugung eines Plasmas 21 (vgl. Fig. 7 unten) in der (in Fig. 7 nicht dargestellten) Kammer 14 zu fokussieren, und zwar indem eine in der Kammer 14 angeordnete (Raum-)Blende 35 zu diesem Zweck verwendet wird. Die (Raum-)Blende 35 ist rotationssymmetrisch zu einer Mittelachse ausgebildet, die mit der in Fig. 7 mit einer strichpunktierten Linie dargestellten Strahlachse der Laserstrahlung 7, 7a zusammenfällt, was durch eine geeignete Justage der Blende 35 erreicht werden kann.

Das Strahlprofil der Anregungs-Laserstrahlung 28 wird im gezeigten Beispiel mit Hilfe eines (nicht bildlich dargestellten) Axicons der Zuführungseinrichtung 26 geformt, um ein rotationssymmetrisches Strahlprofil zu erzeugen, dessen Strahl-Zentrum keine bzw. nur eine geringe Intensität aufweist, so dass das Strahlprofil der Anregungs-Laserstrahlung 28 einen zylindrischen Hohlstrahl bildet. Die so geformte Anregungs-Laserstrahlung 28 trifft auf einen teildurchlässigen Spiegel 37, welcher im Strahlengang der von der Strahlquelle 2 erzeugten Laserstrahlung 7 angeordnet und für diese letztere durchlässig ist. Die Anregungs-Laserstrahlung 28, die im gezeigten Beispiel eine von der Laserstrahlung 7 abweichende Wellenlänge von beispielsweise ca. 1030 nm aufweist, wird an dem teildurchlässigen Spiegel 37 parallel zur Strahlachse bzw. zur Strahlrichtung R1 der Laserstrahlung 7 umgelenkt, so dass das Zentrum des auf diese Weise gebildeten Hohlstrahls der Anregungs-Laserstrahlung 28 mit dem Zentrum der Blendenöffnung der Blende 35 zusammenfällt.

Die Anregungs-Laserstrahlung 28 trifft somit an einer zweiten Seite 36b auf die Blende 35 auf und der Hohlstrahl spart hierbei die Blendenöffnung 38 aus, so dass die Anregungs-Laserstrahlung 28 nicht durch die Blendenöffnung 38 hindurch tritt und zur ersten, der Strahlquelle 2 zugewandten Seite 36a der Blende 35 gelangt. Auf diese Weise ist sichergestellt, dass die Anregungs-Laserstrahlung 28 nicht weiter entlang der zweiten Richtung R2 auf die Strahlquelle 2 zu propagiert.

Die Blende 35, genauer gesagt eine jeweilige Seite 36a, 36b der Blende 35, ist im gezeigten Beispiel konisch ausgebildet, d.h. eine jeweilige Seite 36a, 36b der Blende 35 verläuft ausgehend von der Blendenöffnung 38 in radialer Richtung nicht senkrecht, sondern unter einem von 90° verschiedenen Winkel zur Strahlachse der Laserstrahlung 7, 7a. An der rotationssymmetrischen, konischen Fläche, die an der zweiten Seite 36b der Blende 35 gebildet ist, wird die Anregungs-Laserstrahlung 28 in radialer Richtung nach innen, d.h. in Richtung auf die Strahlachse der von der Strahlquelle 2 erzeugten Laserstrahlung 7 reflektiert.

Die an der zweiten Seite 36b der Blende 35 reflektierte Anregungs-Laserstrahlung 28 bildet einen Bessel-Strahl mit einer langgezogenen Fokuszone im Bereich der Strahlachse der Laserstrahlung 7, an der das Plasma 21 gebildet wird. Bei dem in Fig. 7 gezeigten Beispiel wird das Plasma 21 somit nicht an dem Laserstrahlfokus 18 der von der Strahlquelle 2 erzeugten Laserstrahlung 7, der in Fig. 7 innerhalb der Blendenöffnung 38 liegt, sondern an einem von der Blende 35 beabstandeten Ort gezündet, an dem die Anregungs-Laserstrahlung 28 fokussiert wird.

Bei der in Zusammenhang mit Fig. 5 bis Fig. 7 beschriebenen aktiven Plasmaerzeugung, bei welcher der Anregungslaser 25 als Plasmaerzeugungseinrichtung dient, kann das Plasma 21 in der Kammer 14 nicht nur während der Zeitdauer der gepulsten rückreflektierten Laserstrahlung 7a zur Verhinderung von deren Durchtritt durch die Kammer 14, sondern grundsätzlich während der gesamten Zeitspanne gezündet werden, in der die in der ersten Richtung R1 propagierende Laserstrahlung 7 nicht durch die Kammer 14 hindurch tritt.

Insbesondere kann der Anregungslaser 25 das Plasma 21 auch bzw. zusätzlich zur Zeitdauer, die für die Unterdrückung der in der zweiten Richtung R2 propagierenden Laserstrahlung 7a benötigt wird, zwischen dem Austritt der in der ersten Richtung R1 propagierenden Laserstrahlung 7 aus der Kammer 14 und dem Eintritt der in der zweiten Richtung R2 propagierenden Laserstrahlung 7a zünden. Ebenso kann der Anregungslaser 25 mit Hilfe der Steuerungseinrichtung 34 angesteuert werden, das Plasma 21 auch nach der Unterdrückung des Durchtritts der in der zweiten Richtung R2 propagierenden Laserstrahlung 7a und vor dem Eintritt von weiterer in der ersten Richtung R1 propagierender Laserstrahlung 7 (in Form eines nachfolgenden Laserpulses) zu erzeugen. Auf diese Weise kann das so genannte Self-Lasing, d.h. das unerwünschte Anschwingen von Lasermoden in der Verstärkeranordnung 3, genauer gesagt in deren optischen Verstärkern 4a-e unterbunden werden, da diese auch in den Pulspausen, in denen keine in der ersten Richtung R1 bzw. in der zweiten Richtung R2 propagierende Laserstrahlung 7, 7a durch die Kammer 14 tritt, optisch voneinander entkoppelt werden. Die optische Entkopplung bzw. die Unterdrückung von Self-Lasing durch das Plasma 21 ist größer, als dies bei der optischen Entkopplung nur durch die Verwendung der (Raum-)Blende 35 der Fall wäre.

Der Anregungslaser 25 kann bei der in Fig. 5 gezeigten EUV-Strahlungserzeugungsvorrichtung 1 auch dazu verwendet werden, lediglich die Plasmazündschwelle I_{Z} anzupassen bzw. zu reduzieren, so dass das Plasma 21 von der in der zweiten Richtung R2 propagierenden Laserstrahlung 7a gezündet werden kann, auch wenn diese eine vergleichsweise geringe Intensität I₂ aufweist, die ohne die Anregungs-Laserstrahlung 28 nicht für die Zündung des Plasmas 21 ausreichen würde. Auch kann die Intensität I_{A} der Anregungs-Laserstrahlung 28 nur so weit erhöht werden, dass zwar die Plasmazündschwelle I_{Z} überschritten wird, aber das auf diese Weise erzeugte Plasma 21 nicht ausreicht, um die in der zweiten Richtung R2 propagierende Laserstrahlung 7a vollständig zu unterdrücken. In diesem Fall wird jedoch ein Teil der in der zweiten Richtung R2 propagierenden Laserstrahlung 7a in dem Plasma 21 absorbiert, was zu einer weiteren Ausbreitung des Plasmas 21 und somit zur Ausbildung der vollen Filterleistung des jeweiligen optischen Isolators 4a-e führt.

Zusätzlich zur Verwendung der weiter oben beschriebenen optischen Isolatoren 13, 13a-c, die auf dem Prinzip der optischen Isolation durch die Zündung eines Plasmas 21 beruhen, werden in der Treiberlaseranordnung 12 ggf. weitere optische Isolatoren in Form von herkömmlichen (Faraday-)Isolatoren oder dergleichen verwendet. Deren Anwendungsbereich ist jedoch auf vergleichsweise geringe Laserleistungen beschränkt, so dass diese typischer Weise nur in der Strahlquelle 2 hinter einem jeweiligen CO₂-Laser 2a, 2b und ggf. hinter dem ersten optischen Verstärker 4a (und vor dem ersten optischen Isolator 13a) verwendet werden, da die dort auftretende Leistung der Laserstrahlung 7, 7a in der Regel nicht zu deren Beschädigung bzw. Zerstörung führen.

## Patentansprüche

1. Treiberlaseranordnung (12) für eine EUV-Strahlungserzeugungsvorrichtung (1), umfassend:
eine Strahlquelle (2) zur Erzeugung von Laserstrahlung (7), die in einer ersten Richtung (R1) propagiert,
eine Verstärkeranordnung (3) mit mindestens einem optischen Verstärker (4a-e) zur Verstärkung der in der ersten Richtung (R1) propagierenden Laserstrahlung (7), sowie
mindestens einen optischen Isolator (13, 13a-c),
wobei der optische Isolator (13, 13a-c) eine mit einem Gas (20) gefüllte Kammer (14) aufweist, die von der in der ersten Richtung (R1) propagierenden Laserstrahlung (7) durchlaufen wird, und
wobei der optische Isolator (13, 13a-c) eine Plasmaerzeugungseinrichtung (16, 17; 16a,b, 17a,b; 25) aufweist, die zur gepulsten Zündung eines Plasmas (21) durch direkte Einwirkung bzw. Wechselwirkung mit dem in der Kammer (14) befindlichen Gas (20) ausgebildet ist, um einen Durchtritt von Laserstrahlung (7a), die in einer zweiten, der ersten entgegen gesetzten Richtung (R2) propagiert, durch die Kammer (14) zu unterdrücken, und wobei der optische Isolator (13, 13a-c) einen Gaskreislauf (19) zur Zuführung des Gases (20) in die Kammer (14) und zur Abführung des Gases (20) aus der Kammer (14) aufweist.

2. Treiberlaseranordnung nach Anspruch 1, weiter umfassend: eine Fokussiereinrichtung (16, 16a,b) zur Fokussierung der in der ersten Richtung (R1) propagierenden Laserstrahlung (7) auf einen Laserstrahlfokus (18, 18a,b) in der Kammer (14), sowie bevorzugt eine Kollimationseinrichtung (17, 17a,b) zur Kollimation der von dem Laserstrahlfokus (18, 18a,b) ausgehenden, in der ersten Richtung (R1) propagierenden Laserstrahlung (7).

3. Treiberlaseranordnung nach Anspruch 1 oder 2, bei welcher der optische Isolator (13, 13a-c), insbesondere die Plasmaerzeugungseinrichtung (16a,b, 17a,b; 25), ausgebildet ist, eine Plasmazündschwelle (I_{Z}) zur Zündung des Plasmas (21) in

4. Treiberlaseranordnung nach Anspruch 3, bei der die Fokussiereinrichtung (16a,b) und/oder die Kollimationseinrichtung (17a,b) zur Einstellung eines Fokusdurchmessers (D) des Laserstrahlfokus (18) in der Kammer (14) ausgebildet sind.

5. Treiberlaseranordnung nach Anspruch 4, bei welcher die Fokussiereinrichtung (16a,b) und/oder die Kollimationseinrichtung (17a,b) mindestens ein entlang einer Strahlrichtung der Laserstrahlung (7) verschiebbares und/oder mindestens ein optisches Element (16a,b, 17a,b) mit einstellbarer Brennweite (f₁, f₂) umfasst.

6. Treiberlaseranordnung nach einem der Ansprüche 3 bis 5, bei welcher der optische Isolator (13) eine Gasdruck-Einstelleinrichtung (22, 23) zur Einstellung eines Gasdrucks (p) des Gases (20) in der Kammer (14) aufweist.

7. Treiberlaseranordnung nach Anspruch 6, bei der die Gasdruck-Einstelleinrichtung (22, 23) zur Erzeugung einer stehenden akustischen Welle (24) in der Kammer (14), insbesondere im Bereich des Laserstrahlfokus (18), ausgebildet ist.

8. Treiberlaseranordnung nach einem der Ansprüche 3 bis 7, bei welcher der optische Isolator (13, 13a-c) eine Einrichtung (19a) zur Einstellung einer Zusammensetzung des Gases (20) in der Kammer (14) aufweist.

9. Treiberlaseranordnung nach einem der vorhergehenden Ansprüche, bei welcher die Plasmaerzeugungseinrichtung einen Anregungslaser (25), bevorzugt einen Kurzpuls-Laser oder einen Ultrakurzpuls-Laser, zur Erzeugung von Anregungs-Laserstrahlung (28) aufweist, und bei welcher die Treiberlaseranordnung (12) eine Zuführungseinrichtung (26) zur Zuführung der Anregungs-Laserstrahlung (28) in die Kammer (14) zur Aufheizung des Gases (20) in der Kammer (14), insbesondere im Bereich des Laserstrahlfokus (18), aufweist.

10. Treiberlaseranordnung nach Anspruch 9, bei welcher die Zuführungseinrichtung (26) eine Fokussieroptik (27) zur Fokussierung der Anregungs-Laserstrahlung (28) in der Kammer (14) aufweist.

11. Treiberlaseranordnung nach Anspruch 10, bei welcher in der Kammer (14) eine Blende (35) angeordnet ist, durch deren Blendenöffnung (38) die in der ersten Richtung (R1) propagierende Laserstrahlung (7) hindurch tritt, wobei eine Seite (35b) der Blende (35) eine reflektierende Fokussieroptik zur Fokussierung der Anregungs-Laserstrahlung (28) bildet.

12. Treiberlaseranordnung nach Anspruch 11, bei welcher die Zuführungseinrichtung (26) ausgebildet ist, die Anregungs-Laserstrahlung (28) in Form eines die Blendenöffnung (38) aussparenden Hohlstrahls auf die bevorzugt der Strahlquelle (2) abgewandte Seite (36b) der Blende (35) einzustrahlen.

13. Treiberlaseranordnung nach einem der Ansprüche 9 bis 12, welche eine Steuerungseinrichtung (34) aufweist, die ausgebildet ist, den Anregungslaser (25) zur Erzeugung der Anregungs-Laserstrahlung (28) für die Zündung eines Plasmas (21) in dem Gas (20) der Kammer (14) auch zwischen dem Austritt der in der ersten Richtung (R1) propagierenden Laserstrahlung (7) aus der Kammer (14) und dem Eintritt der in der zweiten Richtung (R2) propagierenden Laserstrahlung (7a) in die Kammer (14) anzusteuern.

14. Treiberlaseranordnung nach einem der Ansprüche 9 bis 13, weiter umfassend:
ein schaltbares Element (30) zur Selektion von Pulsen der Anregungs-Laserstrahlung (28).

15. Treiberlaseranordnung nach einem der Ansprüche 9 bis 14, welche mindestens zwei optische Isolatoren (13a-c) umfasst, wobei die Zuführungseinrichtung (26) mindestens einen Strahlteiler (32a, 32b) zur Aufteilung der Anregungs-Laserstrahlung (28) auf die optischen Isolatoren (13a-c) aufweist.

16. Treiberlaseranordnung nach Anspruch 15, bei der die Zuführungseinrichtung (26) mindestens eine Verzögerungsstrecke (31a, 31b) zur Verzögerung der Anregungs-Laserstrahlung (28) vor der Zuführung zu mindestens einem optischen Isolator (13a-c) aufweist.

17. EUV-Strahlungserzeugungsvorrichtung (1), umfassend:
eine Treiberlaseranordnung (12) nach einem der vorhergehenden Ansprüche, eine Vakuum-Kammer (11), in der ein Target-Material (8) anordenbar ist, sowie eine Strahlführungseinrichtung (5) zur Führung der in der ersten Richtung (R1) propagierenden Laserstrahlung (7, 7a) von der Treiberlaseranordnung (12) zu dem Target-Material (8).

## Claims

1. Driver laser arrangement (12) for an EUV radiation producing apparatus (1), comprising:
a beam source (2) for producing laser radiation (7) propagating in a first direction (R1),
an amplifier arrangement (3) comprising at least one optical amplifier (4a-e) for amplifying the laser radiation (7) propagating in the first direction (R1), and
at least one optical isolator (13, 13a-c),
wherein the optical isolator (13, 13a-c) comprises a chamber (14) filled with a gas (20), through which chamber the laser radiation (7) propagating in the first direction (R1) passes, and
wherein the optical isolator (13, 13a-c) comprises a plasma generating device (16, 17; 16a,b, 17a,b; 25) configured for the pulsed ignition of a plasma (21) by direct action or interaction with the gas (20) situated in the chamber (14) in order to suppress passage of laser radiation (7a) propagating in a second direction (R2), opposite to the first direction, through the chamber (14), and wherein the optical isolator (13, 13a-c) comprises a gas circuit (19) for feeding the gas (20) into the chamber (14) and for discharging the gas (20) from the chamber (14).

2. The driver laser arrangement as claimed in claim 1, further comprising: a focusing device (16, 16a,b) for focusing the laser radiation (7) propagating in the first direction (R1) onto a laser beam focus (18, 18a,b) in the chamber (14), and preferably a collimation device (17, 17a,b) for collimating the laser radiation (7) emanating from the laser beam focus (18, 18a,b) and propagating in the first direction (R1).

3. The driver laser arrangement as claimed in claim 1 or 2, wherein the optical isolator (13, 13a-c), in particular the plasma generating device (16a,b, 17a,b; 25), is configured to set a plasma ignition threshold (I_{Z}) for the ignition of the plasma (21) in the chamber (20).

4. The driver laser arrangement as claimed in claim 3, wherein the focusing device (16a,b) and/or the collimation device (17a,b) are/is configured for setting a focus diameter (D) of the laser beam focus (18) in the chamber (14).

5. The driver laser arrangement as claimed in claim 4, wherein the focusing device (16a,b) and/or the collimation device (17a,b) comprise(s) at least one optical element (16a, b, 17a, b) displaceable along a beam direction of the laser radiation (7) and/or at least one optical element (16a,b, 17a,b) having a settable focal length (f₁, f₂).

6. The driver laser arrangement as claimed in any of claims 3 to 5, wherein the optical isolator (13) comprises a gas pressure setting device (22, 23) for setting a gas pressure (p) of the gas (20) in the chamber (14).

7. The driver laser arrangement as claimed in claim 6, wherein the gas pressure setting device (22, 23) is configured for generating a standing acoustic wave (24) in the chamber (14), in particular in the region of the laser beam focus (18).

8. The driver laser arrangement as claimed in any of claims 3 to 7, wherein the optical isolator (13, 13a-c) comprises a device (19a) for setting a composition of the gas (20) in the chamber (14).

9. The driver laser arrangement as claimed in any of the preceding claims, wherein the plasma generating device comprises an excitation laser (25), preferably a short-pulse laser or an ultrashort-pulse laser, for producing excitation laser radiation (28), and wherein the driver laser arrangement (12) comprises a feeding device (26) for feeding the excitation laser radiation (28) into the chamber (14) for the purpose of heating the gas (20) in the chamber (14), in particular in the region of the laser beam focus (18).

10. The driver laser arrangement as claimed in claim 9, wherein the feeding device (26) comprises a focusing optical unit (27) for focusing the excitation laser radiation (28) in the chamber (14).

11. The driver laser arrangement as claimed in claim 10, wherein a diaphragm (35) is arranged in the chamber (14), and the laser radiation (7) propagating in the first direction (R1) passes through the diaphragm aperture (38) of said diaphragm, wherein one side (35b) of the diaphragm (35) forms a reflective focusing optical unit for focusing the excitation laser radiation (28).

12. The driver laser arrangement as claimed in claim 11, wherein the feeding device (26) is configured to radiate the excitation laser radiation (28) in the form of a hollow beam omitting the diaphragm aperture (38) onto the side (36b) of the diaphragm (35) preferably facing away from the beam source (2).

13. The driver laser arrangement as claimed in any of claims 9 to 12, which comprises a control device (34) configured to drive the excitation laser (25) for producing the excitation laser radiation (28) for the ignition of a plasma (21) in the gas (20) of the chamber (14) also between the emergence of the laser radiation (7) propagating in the first direction (R1) from the chamber (14) and the entrance of the laser radiation (7a) propagating in the second direction (R2) into the chamber (14).

14. The driver laser arrangement as claimed in any of claims 9 to 13, further comprising: a switchable element (30) for selecting pulses of the excitation laser radiation (28).

15. The driver laser arrangement as claimed in any of claims 9 to 14, which comprises at least two optical isolators (13a-c), wherein the feeding device (26) comprises at least one beam splitter (32a, 32b) for splitting the excitation laser radiation (28) between the optical isolators (13a-c).

16. The driver laser arrangement as claimed in claim 15, wherein the feeding device (26) comprises at least one delay section (31a, 31b) for delaying the excitation laser radiation (28) before the feeding to at least one optical isolator (13a-c).

17. An EUV radiation producing apparatus (1), comprising:
a driver laser arrangement (12) as claimed in any of the preceding claims,
a vacuum chamber (11), in which a target material (8) is arrangeable, and a beam guiding device (5) for guiding the laser radiation (7, 7a) propagating in the first direction (R1) from the driver laser arrangement (12) to the target material (8).

## Revendications

1. Arrangement laser d'attaque (12) pour un système de génération de rayonnement EUV (1), comprenant :
une source de rayons (2) destinée à générer un rayonnement laser (7) qui se propage dans une première direction (R1),
un arrangement amplificateur (3) comprenant au moins un amplificateur optique (4a-e) destiné à amplifier le rayonnement laser (7) qui se propage dans la première direction (R1), ainsi
qu'au moins un isolateur optique (13, 13a-c),
l'isolateur optique (13, 13a-c) possédant une chambre (14) remplie d'un gaz (20) à travers laquelle passe le rayonnement laser (7) qui se propage dans la première direction (R1), et
l'isolateur optique (13, 13a-c) possédant un dispositif générateur de plasma (16, 17 ; 16a,b, 17a,b ; 25), qui est configuré pour l'allumage pulsé d'un plasma (21) par effet direct ou par interaction avec le gaz (20) qui se trouve dans la chambre (14), afin d'inhiber un passage à travers la chambre (14) du rayonnement laser (7a) qui se propage dans la direction opposée (R2), et
l'isolateur optique (13, 13a-c) possédant un circuit de gaz (19) destiné à l'acheminement du gaz (20) dans la chambre (14) et à l'évacuation du gaz (20) hors de la chambre (14).

2. Arrangement laser d'attaque selon la revendication 1, comprenant en outre : un dispositif de focalisation (16, 16a,b) destiné à focaliser le rayonnement laser (7) qui se propage dans la première direction (R1) sur un foyer de rayon laser (18, 18a,b) dans la chambre (14), ainsi que de préférence un dispositif de collimation (17, 17a,b) destiné à collimater le rayonnement laser (7) qui se propage dans la première direction (R1) émanant du foyer de rayon laser (18, 18a,b).

3. Arrangement laser d'attaque selon la revendication 1 ou 2, dans lequel l'isolateur optique (13, 13a-c), notamment le dispositif générateur de plasma (16a,b, 17a,b ; 25), est configuré pour régler un seuil d'allumage de plasma (I_{Z}) pour l'allumage du plasma (21) dans la chambre (20).

4. Arrangement laser d'attaque selon la revendication 3, dans lequel le dispositif de focalisation (16a,b) et/ou le dispositif de collimation (17a,b) sont configurés pour régler le diamètre de foyer (D) du foyer de rayon laser (18) dans la chambre (14).

5. Arrangement laser d'attaque selon la revendication 4, dans lequel le dispositif de focalisation (16a,b) et/ou le dispositif de collimation (17a,b) comportent au moins un élément optique (16a,b, 17a,b) pouvant être déplacé le long de la direction du rayon du rayonnement laser (7) et/ou au moins un ayant une distance focale (f₁, f₂) réglable.

6. Arrangement laser d'attaque selon l'une des revendications 3 à 5, dans lequel l'isolateur optique (13) possède un dispositif de réglage de pression de gaz (22, 23) destiné à régler une pression de gaz (p) du gaz (20) dans la chambre (14).

7. Arrangement laser d'attaque selon la revendication 6, dans lequel le dispositif de réglage de pression de gaz (22, 23) est configuré pour générer une onde acoustique stationnaire (24) dans la chambre (14), notamment dans la zone du foyer de rayon laser (18).

8. Arrangement laser d'attaque selon l'une des revendications 3 à 7, dans lequel l'isolateur optique (13, 13a-c) possède un dispositif (19a) destiné à régler une composition du gaz (20) dans la chambre (14).

9. Arrangement laser d'attaque selon l'une des revendications précédentes, dans lequel le dispositif générateur de plasma possède un laser d'excitation (25), de préférence un laser à impulsions courtes, destiné à générer un rayonnement laser d'excitation (28), et dans lequel l'arrangement laser d'attaque (12) possède un dispositif d'amenée (26) destiné à amener le rayonnement laser d'excitation (28) dans la chambre (14) en vue de chauffer le gaz (20) dans la chambre (14), notamment dans la zone du foyer de rayon laser (18).

10. Arrangement laser d'attaque selon la revendication 9, dans lequel le dispositif d'amenée (26) possède une optique de focalisation (27) destinée à focaliser le rayonnement laser d'excitation (28) dans la chambre (14) .

11. Arrangement laser d'attaque selon la revendication 10, dans lequel un diaphragme (35) est disposé dans la chambre (14), à travers l'ouverture de diaphragme (38) duquel passe le rayonnement laser (7) qui se propage dans la première direction (R1), un côté (35b) du diaphragme (35) formant une optique de focalisation réfléchissante servant à la focalisation du rayonnement laser d'excitation (28).

12. Arrangement laser d'attaque selon la revendication 11, dans lequel le dispositif d'amenée (26) est configuré pour injecter le rayonnement laser d'excitation (28) sous la forme d'un rayon creux qui évide l'ouverture de diaphragme (38) sur le côté (36b) du diaphragme (35) de préférence à l'opposé de la source de rayons (2).

13. Arrangement laser d'attaque selon l'une des revendications 9 à 12, lequel possède un dispositif de commande (34) qui est configuré pour commander le laser d'excitation (25) destiné à générer un rayonnement laser d'excitation (28) pour l'allumage d'un plasma (21) dans le gaz (20) de la chambre (14) également entre la sortie hors de la chambre (14) du rayonnement laser (7) qui se propage dans la première direction (R1) et l'entrée dans la chambre (14) du rayonnement laser (7a) qui se propage dans la deuxième direction (R2).

14. Arrangement laser d'attaque selon l'une des revendications 9 à 13, comprenant en outre : un élément commutable (30) servant à la sélection d'impulsions du rayonnement laser d'excitation (28).

15. Arrangement laser d'attaque selon l'une des revendications 9 à 14, lequel comporte au moins deux isolateurs optiques (13a-c), le dispositif d'amenée (26) possédant au moins un diviseur de faisceau (32a, 32b) destiné à répartir le rayonnement laser d'excitation (28) sur les isolateurs optiques (13a-c).

16. Arrangement laser d'attaque selon la revendication 15, le dispositif d'amenée (26) possédant au moins un segment de ralentissement (31a, 31b) destiné à ralentir le rayonnement laser d'excitation (28) avant l'amenée vers au moins un isolateur optique (13a-c).

17. Système de génération de rayonnement EUV (1), comprenant :
un arrangement laser d'attaque (12) selon l'une des revendications précédentes,
une chambre sous vide (11) dans laquelle peut être disposé un matériau cible (8) ainsi
qu'un dispositif de guidage de rayon (5) destiné à guider le rayonnement laser (7, 7a) qui se propage dans la première direction (R1) de l'arrangement laser d'attaque (12) vers le matériau cible (8).
